# FASCICULE DE BREVET EUROPEEN

(11) **EP 1 975 943 B1**
(45) Date de publication et mention de la délivrance du brevet: **07.03.2012**
(21) Numéro de dépôt: 08102846.6
(22) Date de dépôt: 21.03.2008
(51) Int. Cl.: G11C 17/12, H01L 21/8246, H01L 27/112

(54) **Codage logique dans un circuit intégré**
Logische Kodierung in einem integrierten Schaltkreis
Logical coding in an integrated circuit

(30) Priorité: 29.03.2007 FR 0754134
(43) Date de publication de la demande: 01.10.2008
(73) Titulaire: STMicroelectronics (Rousset) SAS, 13790 Rousset (FR)
(72) Inventeur: Fornara, Pascal, 83910 Pourrières (FR)
(74) Mandataire: de Beaumont, Michel

(56) Documents cités:
- EP-A- 0 845 811
- EP-A- 1 310 987
- US-B1- 6 243 284

## Description

### Domaine de l'invention

La présente invention concerne de façon générale les circuits intégrés et, plus particulièrement, le stockage de façon non volatile dans un circuit intégré d'un codage fixé à la fabrication de ce circuit.

Un exemple d'application de l'invention concerne les mémoires non volatiles à lecture seulement (ROM). Un autre exemple concerne les interconnexions logiques au sein d'un circuit intégré.

### Exposé de l'art antérieur

Dans de nombreux cas, on a besoin de coder de façon définitive à la fabrication du circuit intégré des mots numériques en mémoire ou des états logiques conditionnant le fonctionnement du circuit. Pour ce faire, on utilise généralement une mémoire de type ROM dans laquelle le codage s'effectue en interconnectant les drain et source de transistors constituant les cellules mémoire, de sorte que l'état lu dans la cellule dépend de la présence de cette connexion. On utilise généralement le premier niveau de métallisation de la structure pour effectuer cette programmation.

Un inconvénient d'une telle programmation est qu'elle se trouve visible par analyse du masque de réalisation du niveau d'interconnexion, par exemple par reconstitution de ce masque à partir d'un circuit (reverse engineering). EP 1 310 987 décrit un procédé de fabrication d'une ROM dans lequel la programmation dépend de l'introduction ou non d'impuretés dans la région de canal des transistors NMOS.

### Résumé de l'invention

La présente invention vise à pallier tout ou partie des inconvénients des solutions connues de codage à la fabrication d'un circuit intégré d'un état logique.

Un objet vise plus particulièrement la réalisation d'une mémoire à lecture seulement.

Un autre objet vise à rendre la programmation de l'état logique invisible par analyse du masque de définition des niveaux d'interconnexion de la structure.

Un autre objet vise une solution compatible avec les circuits d'interprétation actuels des états logiques et notamment des mémoires à lecture seulement.

Pour atteindre tout ou partie de ces objets ainsi que d'autres, il est prévu un procédé de programmation d'une mémoire à lecture seulement formée de transistors MOS selon la revendication 1.

Selon un mode de mise en oeuvre, des lignes d'interconnexion en série de plusieurs transistors dans une première direction sont réalisées, avec un motif indépendant de la programmation, dans ledit niveau conducteur.

Selon un mode de mise en oeuvre, ladite couche isolante est une bicouche d'oxyde et de nitrure.

Il est également prévu une structure d'interconnexion entre deux niveaux logiques d'un circuit intégré selon la revendication 4.

Il est également prévu une cellule mémoire à lecture seulement formée d'un transistor MOS selon la revendication 5.

Il est également prévu une mémoire à lecture seulement.

Selon un mode de réalisation, des pistes d'interconnexion de contacts de drain et de source des transistors dans une première direction sont ininterrompues.

### Brève description des dessins

Ces objets, caractéristiques et avantages, ainsi que d'autres seront exposés en détail dans la description suivante de modes de mise en oeuvre et de réalisation particuliers faite à titre non-limitatif en relation avec les figures jointes parmi lesquelles :
la figure 1 est un schéma-bloc partiel d'un circuit intégré du type auquel s'applique à titre d'exemple la présente invention ;
la figure 2 est un schéma-bloc d'une mémoire à lecture seulement du type à laquelle s'applique la présente invention ;
la figure 3 est un schéma électrique partiel du réseau de cellules de la figure 2 ;
la figure 4 est une vue de dessus du réseau partiel de la figure 3 programmé de façon usuelle ;
la figure 5 est une vue en coupe du réseau de la figure 4 ;
les figures 6A, 6B, 6C, 6D, 6E, 6F, 6G et 6H sont des vues en coupe dans une première direction d'états intermédiaires d'un mode de fabrication d'une mémoire à lecture seulement ;
les figures 7A, 7B, 7C, 7D, 7E, 7F, 7G et 7H sont des vues en coupe dans une deuxième direction d'états intermédiaires d'un mode de fabrication d'une mémoire à lecture seulement ; et
la figure 8 est une vue de dessus d'un mode de réalisation d'un réseau partiel respectant la fonction électrique de la figure 3.

De mêmes éléments ont été désignés par de mêmes références aux différentes figures qui ont été tracées sans respect d'échelle.

### Description détaillée

Par souci de clarté, seuls les étapes et éléments qui sont utiles à la compréhension de l'invention ont été représentés et seront décrits. En particulier, les étapes de fabrication d'un circuit intégré pour réaliser des points mémoire stockant des états de façon non volatile n'ont pas été détaillées autrement que pour faire référence à des étapes habituelles de fabrication de tels éléments. De plus, l'exploitation faite des mémoires à lecture seulement ou des interconnexions logiques n'a pas non plus été détaillée, celle-ci étant compatible avec toute utilisation usuelle de tels circuits.

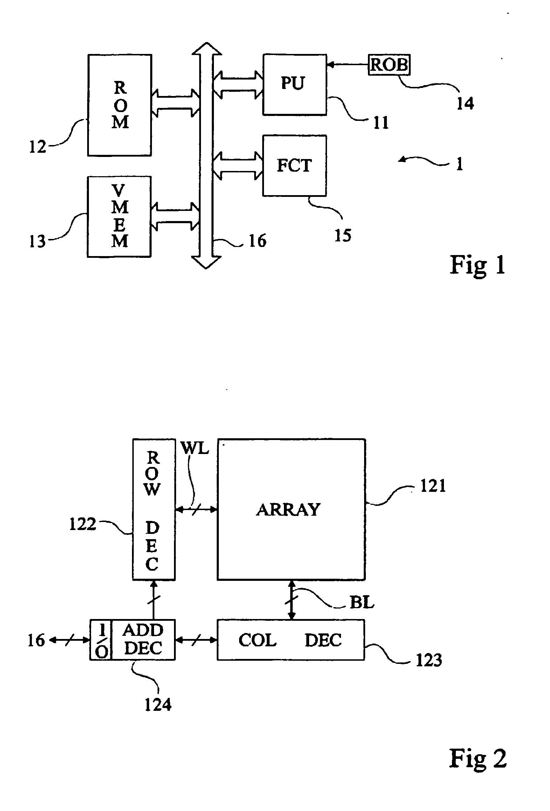

La figure 1 est un schéma-bloc d'un circuit intégré 1 du type auquel s'applique à titre d'exemple la présente invention. Une unité de traitement 11 (PU) communique avec une mémoire à lecture seulement 12 (ROM) stockant, par exemple, des programmes à exécuter par cette unité de traitement. L'unité 11 exploite également une ou plusieurs mémoires volatiles 13 (VMEM), par exemple, une mémoire vive (RAM). Dans l'exemple représenté en figure 1, un ou plusieurs états logiques en lecture seule ROB (Read Only Bit) sont stockés dans des circuits 14 particuliers. Il peut s'agir, par exemple, d'interconnexions logiques réalisées dans le circuit intégré ou de cellules de mémoire à lecture seulement isolées. Ces bits ont été illustrés séparément de la mémoire 12 pour faire ressortir une possibilité de mise en oeuvre non seulement dans une mémoire (réseau matriciel), mais également sur des points d'interconnexion isolés d'autres éléments.

D'autres fonctions (bloc 15, FCT) sont contenues dans le circuit intégré 1 et dépendent de l'application de ce circuit. Tous ces éléments communiquent par l'intermédiaire d'un ou plusieurs bus 16 d'adresses, de données et de commandes, le cas échéant complétés par des connexions directes entre différents éléments du circuit. En variante, la mémoire 12 est un circuit distinct des circuits qui y accèdent.

La figure 2 est un schéma-bloc d'une mémoire à lecture seulement 12 du type auquel s'applique à titre d'exemple la présente invention. Un réseau 121 (ARRAY) de cellules mémoire réparties en lignes et en colonnes est exploité par un décodeur de rangées 122 (ROW DEC) définissant, par ses conducteurs, des lignes de mots (WL). Un décodeur de colonnes combiné à des amplificateurs de lecture (bloc 123, COL DEC/SA) exploite les données par colonne et définit des lignes de bits BL de la structure. Les décodeurs de rangées et de colonnes sont exploités par un circuit de commande 124 incluant un décodeur d'adresses (ADD DEC) et des circuits d'entré/sortie (I/O) reliés, par exemple, aux bus 16 (figure 1).

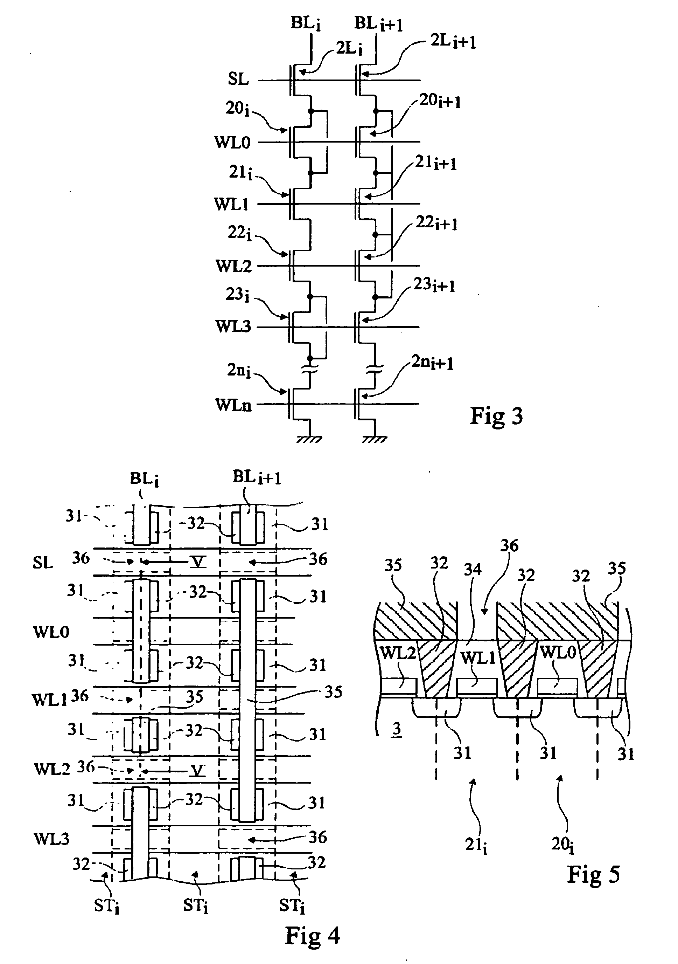

La figure 3 est un schéma électrique partiel d'un réseau de cellules mémoire du type de celui de la figure 2. Chaque cellule 2 est formée par un transistor MOS dont la grille est reliée à la ligne de mot WL et dont les drain et source sont respectivement connectés aux source et drain des transistors constitutifs des cellules précédente et suivante. Les transistors sont donc en série dans la direction des colonnes. En figure 3, les transistors 2 ont été identifiés par le rang 0, 1, 2, 3, ..., n de la ligne de mot WL et par le rang i, i+1 (i allant de 0 à m) de la ligne de bit. Le réseau comporte alors (n+1)*(m+1) cellules. Les transistors 20i et 20ᵢ₊₁ de la première rangée (WLO) ont leurs drains connectés, par l'intermédiaire de transistors 2Li et 2Lᵢ₊₁ d'une rangée de sélection du réseau, aux lignes de bit BLi, BLi+1 tandis que ceux 2ni et 2nᵢ₊₁ de la dernière rangée (WLn) ont leurs sources connectées à un potentiel de référence (généralement la masse). La programmation de chaque cellule est effectuée, lors de la fabrication, en court-circuitant ou non les drain et source de son transistor. Dans l'exemple de la figure 3, les transistors 20ᵢ et 23i de la colonne i et les transistors 20ᵢ₊₁, 21ᵢ₊₁ et 22ᵢ₊₁ de la colonne i+1 sont forcés à l'état passant. L'état logique 0 ou 1 auquel cela correspond dépend du circuit de lecture.

Lors d'une lecture, on commence généralement par sélectionner une ligne de bit au moyen du décodeur de colonnes (figure 2). Puis, on porte à un potentiel positif par rapport au potentiel de référence la ligne de sélection SL. Le conducteur WL de la rangée de la cellule adressée est alors forcé au potentiel de référence pour la sélectionner, toutes les autres lignes de mot étant à un potentiel supérieur (par exemple, à un potentiel haut d'alimentation du circuit). Cela rend conducteurs tous les transistors des rangées autres que celle sélectionnée. Si le transistor 2 de la cellule définie par l'intersection de la rangée et de la colonne adressée est court-circuité, le signal de la ligne de mot n'a pas d'effet. Par conséquent, la ligne de bit correspondante se décharge par la connexion à la masse. Si le transistor n'a pas été court-circuité, il isole la ligne de bit de la masse, et l'amplificateur de sortie de cette ligne voit donc un état haut.

La figure 4 est une vue partielle de dessus illustrant une façon usuelle de réaliser un réseau de cellules de mémoire à lecture seulement et de le programmer pour remplir la fonction électrique de la figure 3.

La figure 5 est une vue en coupe partielle selon le trait mixte V-V de la figure 4.

Les transistors sont formés dans une plaquette en matériau semiconducteur (par exemple, du silicium) dans laquelle des tranchées STI isolent les colonnes de transistors les unes des autres. Les régions actives 31 de drain et de source d'un premier type de conductivité (par exemple N) sont formées dans des caissons 3 (figure 5) d'un deuxième type de conductivité (par exemple P) délimités latéralement par des tranchées d'isolement STI (figure 4). Les grilles des transistors sont formées, par exemple, en silicium polycristallin sur un oxyde de grille selon un motif de conducteurs de rangées dans une direction perpendiculaire à celle des colonnes. Les contacts de drain et de source sont repris par des vias conducteurs 32 dans l'épaisseur de la plaquette, formés à l'aplomb des régions 31 dans une couche isolante 34. Puis, des pistes conductrices 35 sont réalisées pour interconnecter les vias 32 dans la direction des colonnes. La programmation s'effectue à ce niveau (généralement le premier niveau de métallisation) en définissant, dans le masque de formation des pistes 35, des zones d'interruption au-dessus des grilles des transistors à ne pas court-circuiter. Dans la partie visible aux figures 4 et 5, ces interruptions 36 sont prévues entre les vias de reprise de contact des drain et source des transistors 2Li, 21i, 22i, 2Lᵢ₊₁ et 23ᵢ₊₁. Un niveau conducteur supérieur non représenté (par exemple, la deuxième métallisation) sert généralement à connecter les drains des transistors de sélection aux amplificateurs de lecture.

La programmation du plan mémoire est détectable visuellement par le motif du niveau conducteur dans lequel sont réalisés les interruptions 36. Cet examen visuel est aisé en reconstituant le masque de la première métallisation.

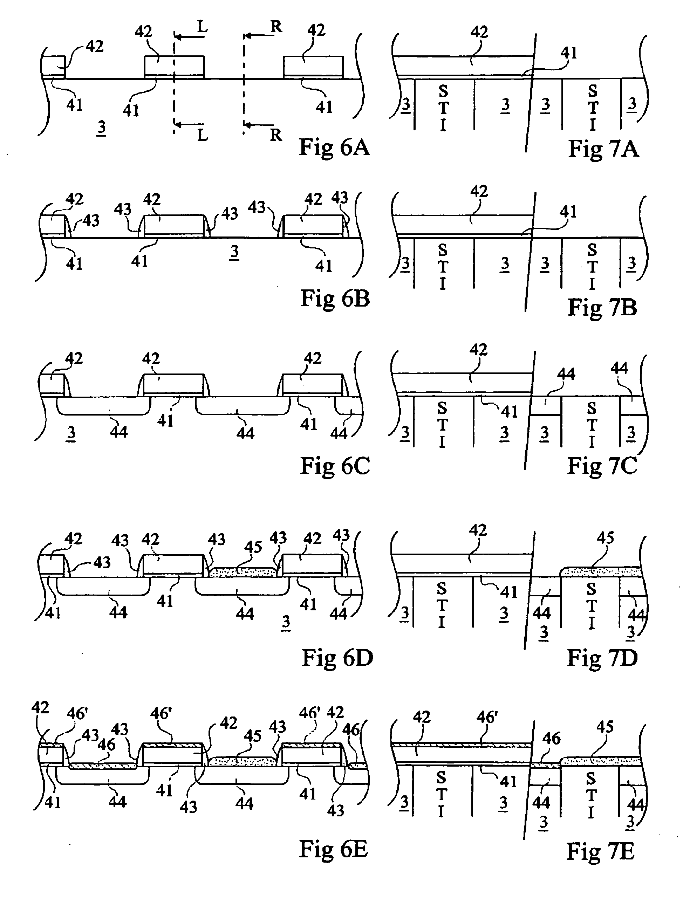

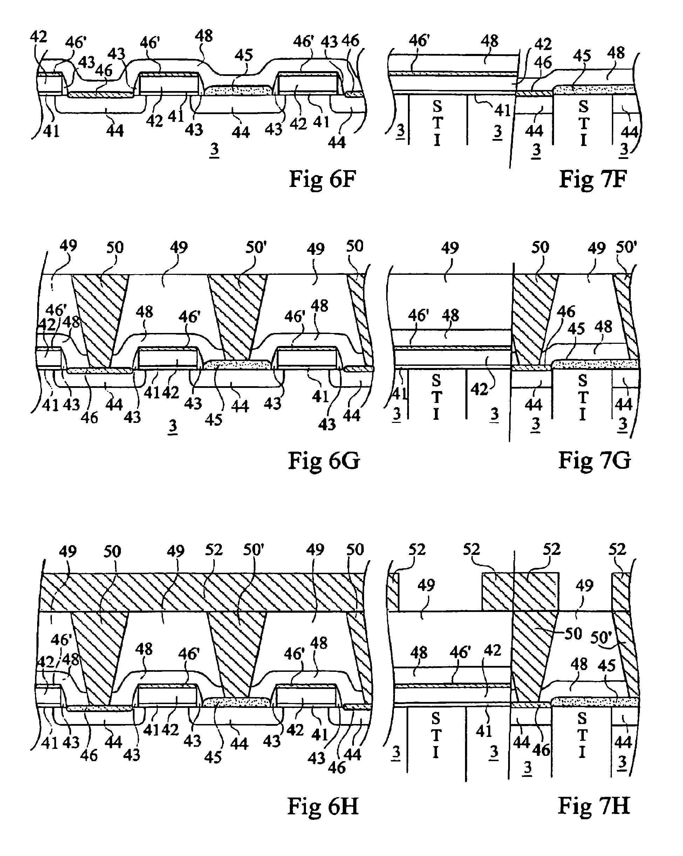

Les figures 6A, 6B, 6C, 6D, 6E, 6F, 6G et 6H sont des vues en coupe dans une première direction (parallèle aux lignes de bit) illustrant des états intermédiaires d'un mode de mise en oeuvre du procédé de fabrication d'une mémoire à lecture seulement.

Les figures 7A, 7B, 7C, 7D, 7E, 7F, 7G et 7H sont des vues en coupe dans une deuxième direction (parallèle aux lignes de mots), perpendiculaire à la première, des états intermédiaires respectivement illustrés aux figures 6A à 6H. Aux figures 7A à 7H, les parties gauches dans l'orientation des dessins (ligne L-L de la figure 6A) représentent des coupes prises sur une ligne de mot alors que les parties droites (ligne R-R de la figure 6A) représentent des coupes prises entre deux lignes de mots.

Comme précédemment, on part d'une plaquette en matériau semiconducteur (par exemple, en silicium) dans laquelle on réalise des tranchées d'isolement STI (figure 7A) entre des caissons 3 d'un type de conductivité (par exemple, de type P) dans une première direction (par exemple, direction des colonnes du réseau matriciel). On fait croître sur la plaquette une couche d'oxyde 41 (futur oxyde de grille) et on dépose sur cet oxyde une couche de silicium polycristallin 42. Puis, le silicium polycristallin 42 et l'oxyde de grille 41 sont gravés pour définir les lignes de grille (figures 6A et 7A) selon le motif des rangées (lignes de mot) dans la direction perpendiculaire aux tranchées STI du substrat, afin de définir les transistors. On effectue alors généralement une première implantation (LDD ou Low Doped Drain) des zones non masquées par les lignes de grilles.

Des couches d'oxyde et de nitrure sont ensuite déposées puis gravées pour former des espaceurs 43 (figures 6B et 7B) de part et d'autre des lignes de grille.

L'étape suivante consiste à implanter un dopant d'un autre type de conductivité (par exemple de type N) que celui des caissons 3 pour former les régions actives 44 de source et de drain des transistors (figures 6C et 7C).

Puis, on réalise un dépôt d'une couche d'oxyde suivi d'une couche de nitrure ayant pour rôle de protéger le silicium des tranchées STI contre une formation ultérieure de siliciure lors de la réalisation des contacts de grille, de drain et de source. On fera par la suite référence à une couche 45 oxyde-nitrure pour désigner ce bicouche car les couches d'oxyde et de nitrure subissent les mêmes traitements.

Selon ce mode de réalisation, la couche 45 est gravée pour subsister, non seulement sur les zones des tranchées STI non recouvertes par les lignes de grilles (figure 7D), mais également sur les régions actives 44 (source/drain) des transistors que l'on souhaite programmer dans un état bloqué (figures 6D et 7D). En effet, la couche 45 est isolante. Dans l'exemple représenté, la couche 45 subsiste sur la région 44 centrale en figure 6D et de droite en figure 7D. L'épaisseur de la couche 45 est de quelques dizaines de nanomètres (par exemple, entre 20 et 50 nanomètres) .

La couche 45 sert alors de masque auto-aligné de formation usuelle des contacts. Le dépôt d'un métal (par exemple du Cobalt) forme avec le silicium du siliciure de Cobalt partout où il y a du silicium polycristallin ou du silicium. On obtient des zones à faible résistance d'accès qui constituent les contacts ponctuels 46 (figures 6E et 7E) de drain et de source et des lignes 46' de contact de grille. On voit que ces contacts n'ont pas été formés là où le silicium était protégé par la couche 45. En effet, la présence de nitrure empêche la réaction métal/silicium et préserve la couche isolante 45.

Reste à réaliser la reprise des contacts par des niveaux conducteurs supérieurs (métallisations). Cette réalisation passe, de façon usuelle, par la formation de vias conducteurs dans une couche isolante rapportée sur la structure. Pour cela, on commence par déposer pleine plaque une couche de nitrure 48 dont le rôle est de rendre sélective la gravure des contacts. Puis, on dépose pleine plaque une couche isolante 49 (oxyde) et on réalise une gravure de ces deux couches 49 et 48 selon un motif de vias à l'aplomb de chaque région active 44. En pratique, une première gravure plasma sélective au nitrure est effectuée avec un mélange gazeux adapté. Puis, lorsque la couche 48 est atteinte, le mélange gazeux est modifié pour poursuivre la gravure, cette fois sélective à l'oxyde, jusqu'à atteindre les contacts 46 ainsi que, hors du plan mémoire, les extrémités des lignes 46'. Du métal est enfin déposé dans les trous obtenus pour former les vias conducteurs 50 de reprise de contact (figures 6G et 7G). Toutefois, lorsqu'ils sont à l'aplomb de zones 45, ces vias 50' ne contactent qu'un isolant. La couche 45 oxyde-nitrure empêche également la gravure de formation des contacts d'atteindre le silicium, ce qui aurait pour effet de créer des courants de fuite.

Enfin, une première métallisation est réalisée selon un tracé de pistes 52 interconnectant les vias 50 et 50' dans le sens des lignes de bits, c'est-à-dire parallèlement aux tranchées STI. D'autres niveaux conducteurs (métallisations) non représentés sont ensuite réalisés pour réaliser les différentes connexions au reste du circuit.

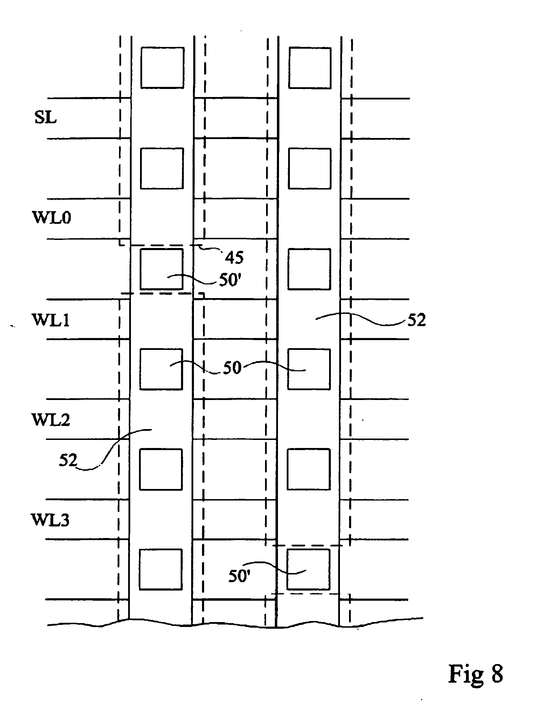

La figure 8 est une vue de dessus de la structure réalisée en reprenant l'exemple de la fonction électrique de la figure 3. Tous les détails des figures précédentes n'ont pas été illustrés. Le motif de la couche 45 est symbolisé par un pointillé.

Par rapport à la réalisation des figures 4 et 5, les pistes d'interconnexion 52 ne sont pas interrompues pour la programmation. Par conséquent, la programmation de la mémoire est invisible vue de dessus de la métallisation 52 ou par analyse du masque de réalisation de cette métallisation, ou encore en effectuant des coupes successives pour une reconstitution de ce masque (Delayering).

Ni masque supplémentaire, ni étape supplémentaire, n'est requis dans la fabrication de la mémoire.

De plus, la programmation réalisée se trouve sous les vias, ce qui la rend encore plus difficilement décelable. Il faut en effet couper chaque ligne de la mémoire pour identifier quels sont les contacts qui sont réellement connectés.

En outre, on peut prévoir d'ajouter des motifs parasites de façon à empêcher une éventuelle analyse du masque de réalisation de la couche 45, par exemple, en réalisant de tels motifs dans les tranchées d'isolement STI. De tels motifs parasites formés à partir de la couche 45 permettent de définir des interconnexions fictives qui peuvent aussi être contactées.

Des modes de réalisation particuliers ont été décrits. Diverses variantes et modifications apparaîtront à l'homme de l'art. En particulier, bien que l'invention ait été décrite en relation avec une mémoire à lecture seulement sous la forme d'un réseau matriciel, elle peut être mise en oeuvre dans n'importe quelle zone du circuit intégré à l'aplomb d'une reprise de contact. De plus, on peut prévoir de réaliser des zones 45 qui isolent des régions actives d'un transistor pour forcer ou interdire de façon invisible une connexion logique entre des éléments du circuit intégré.

En outre, la mise en oeuvre pratique de l'invention est à la portée de l'homme du métier à partir des indications fonctionnelles données ci-dessus, en adaptant le procédé exposé aux variantes liées à l'application et à la technologie utilisée. En particulier, d'autres composés peuvent être utilisés pour réaliser les zones isolantes 45 empêchant la formation des contacts des régions actives (par exemple, une monocouche d'oxyde avec une gravure dont la profondeur est contrôlée sans recours à la sélectivité oxyde-nitrure), et d'autres matériaux conducteurs que des métaux peuvent être utilisés pourvu d'être compatibles avec les fonctionnalités décrites.

Enfin, l'invention s'applique quel que soit le type de conductivité du canal des transistors MOS réalisés et quelles que soient les polarités utilisées pour la lecture.

## Revendications

1. Procédé de programmation d'une mémoire à lecture seulement, acronyme ROM, formée de transistors MOS (20), dans lequel la programmation est fixée par un masque de réalisation d'une couche isolante (45) préalablement à la formation de vias conducteurs (50, 50') de reprise de contacts de régions actives (44) des transistors vers un niveau conducteur supérieur (52), ladite couche isolante étant présente au moins entre les régions actives de certains transistors et des vias correspondants, **caractérisé en ce que** la couche isolante (45) empêche la gravure de formation de ces vias d'atteindre la région active (44) de certains transistors.

2. Procédé selon la revendication 1, dans lequel des lignes (52) d'interconnexion en série de plusieurs transistors dans une première direction sont réalisées, avec un motif indépendant de la programmation, dans ledit niveau conducteur.

3. Procédé selon la revendication 1 ou 2, dans lequel ladite couche isolante (45) est une bicouche d'oxyde et de nitrure.

4. Structure d'interconnexion entre deux niveaux logiques d'un circuit intégré comportant entre une région active (44) sur un substrat semiconducteur et un via (50') connecté à un niveau conducteur supérieur (52), une couche isolante (45) réalisée par un masque **caractérisé en ce que** ladite couche empêche la gravure des vias conducteurs de reprise de contact de la région active d'atteindre cette région active en cas d'absence d'interconnexion.

5. Cellule mémoire à lecture seulement (20), acronyme ROM, formée d'un transistor MOS dont l'état de programmation est fixé par le masque de réalisation d'une couche isolante (45) entre une région active (44) de transistors MOS et un via conducteur (50, 50') de reprise de contact vers un niveau conducteur supérieur, ladite couche isolante étant présente au moins entre les régions actives de certains transistors et de vias correspondants **caractérisé en ce que** ladite couche isolante empêche la gravure de formation de ces vias d'atteindre la région active de certains transistors.

6. Mémoire à lecture seulement, acronyme ROM, comportant au moins une cellule (20) conforme à la revendication 5.

7. Mémoire selon la revendication 6, dans laquelle des pistes (52) d'interconnexion de contacts de drain et de source des transistors dans une première direction sont ininterrompues.

## Claims

1. A method for programming a read-only memory, or ROM, formed of MOS transistors (20), wherein the programming is set by a mask for forming an insulating layer (45) prior to the forming of conductive vias (50, 50') for contacting active regions (44) of the transistors towards an upper conductive level (52), said insulating layer being present at least between the active regions of some transistors and corresponding vias, **characterized in that** the insulating layer (45) prevents the etching of formation of these vias to attain the active region (44) of some transistors.

2. The method of claim 1, wherein the lines (52) for interconnecting several transistors in series in a first direction are formed, with a pattern independent from the programming, in said conductive level.

3. The method of claim 1 or 2, wherein said insulating layer (45) is an oxide and nitride bilayer.

4. An interconnection structure between two logic levels of an integrated circuit, comprising, between an active region (44) on a semiconductor substrate and a via (50') connected to an upper conductive level (52), an insulating layer (45) implemented by a mask, **characterized in that** said layer prevents the etching of formation of the vias to attain the active region in case of a lack of interconnection.

5. A read-only memory cell (20), or ROM, formed of a MOS transistor, wherein the programming state is set by the mask of implementation of an insulating layer (45) between an active region (44) of MOS transistors and a conductive contact recovery via (50, 50') towards an upper conductive level **characterized in that** said insulating layer prevents the etching of formation of the vias to attain the active region of some transistors.

6. A read-only memory, or ROM, comprising at least one cell (20) according to claim 5.

7. The memory of claim 6, wherein tracks (52) for interconnecting drain and source contacts of the transistors in a first direction are uninterrupted.

## Patentansprüche

1. Ein Verfahren zum Programmieren eines Nur-Lese-Speichers oder ROM, der aus MOS-Transistoren (20) gebildet wird, wobei das Programmieren eingestellt wird durch eine Maske zum Ausbilden einer Isolierschicht (45) vor dem Ausbilden von Vias (50, 50'), die aktive Bereiche (44) der Transistoren mit einer oberen leitenden Schicht (52) verbinden, wobei die Isolierschicht wenigstens zwischen den aktiven Bereichen von einigen Transistoren und entsprechenden Vias ausgebildet ist, **dadurch gekennzeichnet, dass** die Isolierschicht (45) beim Ausbilden von Vias mittels ätzen verhindert, dass diese den aktiven Bereich (44) einiger Transistoren erreichen.

2. Verfahren nach Anspruch 1, wobei die Leitungen (52) zum Verbinden mehrerer Transistoren in Serie in einer ersten Richtung ausgebildet werden, und zwar mit einem Muster unabhängig von der Programmierung in der leitenden Schicht.

3. Verfahren nach Anspruch 1 oder 2, wobei die Isolierschicht (45) eine Oxid- und Nitriddoppelschicht ist.

4. Verbindungsstruktur zwischen zwei logischen Schichten einer integrierten Schaltung, die zwischen einem aktiven Bereich (44) auf einem Halbleitersubstrat und einem Via (50') das mit einer oberen leitenden Schicht (52) verbunden ist, eine Isolierschicht (45) aufweist, die durch eine Maske implementiert ist, **dadurch gekennzeichnet, dass** die Schicht beim Ausbilden von Vias mittels ätzen verhindert, dass der aktiven Bereich im Fall des Fehlens einer Zwischenverbindung erreicht wird.

5. Eine Nur-Lese-Zelle (20), oder ein ROM ausgebildet aus einem MOS-Transistor, wobei der Programmierzustand eingestellt wird, durch die Implementierungsmaske einer Isolierschicht (45), die zwischen einem aktiven Bereich (44) von MOS-Transistoren und einem leitenden Via (50, 50') zu einer oberen leitenden Schicht liegt, **dadurch gekennzeichnet, dass** die Isolierschicht beim Ausbilden von Vias mittels ätzen verhindert, dass diese den aktiven Bereich von einigen Transistoren erreichen.

6. Nur-Lese-Speicher oder ROM, das wenigstens eine Zelle (20) nach Anspruch 5 aufweist.

7. Speicher nach Anspruch 6, wobei Leitungen (52) zum Verbinden von Drain- und Source-Kontakten der Transistoren in einer ersten Richtung durchgängig sind.
